Europäisches Patentamt

European Patent Office

Office européen des brevets

(11) Publication number: **0 379 320**
**A1**

## (12) EUROPEAN PATENT APPLICATION

(21) Application number: **90300392.9**

(22) Date of filing: **15.01.90**

(51) Int. Cl.⁵: **H03K 17/78**

(30) Priority: **17.01.89 JP 8312/89**

(43) Date of publication of application:
**25.07.90 Bulletin 90/30**

(84) Designated Contracting States:
**DE FR GB**

(71) Applicant: **FUJI ELECTRIC CO., LTD.**
**1-1, Tanabeshinden, Kawasaki-shi**
**Kawasaki-shi(JP)**

(72) Inventor: **Hiroshi, Miki**
**No. E-304, 1-8-12, Asahigaoka**
**Hino-shi, Tokyo(JP)**
Inventor: **Yasuharu, Seki**
**4-11-20, Nakamachi**
**Koganei-shi, Tokyo(JP)**

(74) Representative: **Gordon, Martin et al**
**G.F. Redfern & Company Marlborough Lodge**
**14 Farncombe Road**
**Worthing West Sussex, BN11 2BT(GB)**

(54) **Photocoupler circuit.**

(57) The main current path of a phototransistor of a photocoupler (2) is connected via a resistor (3) to one side of a power supply (6) whose other side is connected to the other side of the main current path of the phototransistor. The resistor (3) is connected in parallel with the base emitter path of a switching transistor (4) so as to optimise the voltage across the main current path of the phototransistor and to minimise carrier accumulation in the switching transistor. This results in obtaining reliable fast switching of an output device arranged to receive output voltage $V_0$ and enables use of a general-purpose photocoupler of relatively small size and low cost.

Fig 1.

# PHOTOCOUPLER CIRCUIT

The present invention relates to a photocoupler for transmitting, at a high speed, a signal insulated by a photocoupler and particularly to a photocoupler circuit for driving a power semiconductor element which can drive at a high speed said power semiconductor element.

For power conversion with ON-OFF operation of a semiconductor element, the ON-OFF signal to be applied to such semiconductor element is insulated and transmitted by photocoupler. The power conversion by means of pulse width modulation control is required to form a photocoupler circuit to satisfy the requirement that such ON-OFF signal must be transmitted at high speed.

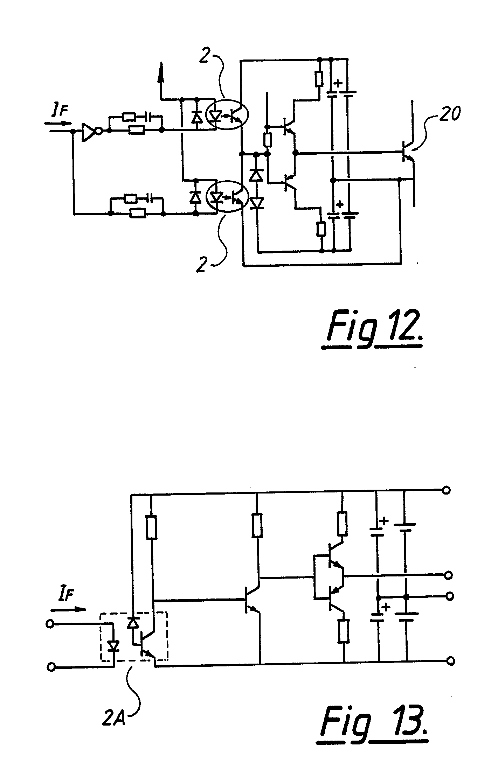

Fig. 12 is a schematic circuit diagram showing a first prior art form of photocoupler circuit for transmitting a signal.

Referring to Fig. 12, a pair of general purpose photocouplers are used to insulate and transmit the ON-OFF signal to a power transistor 20 as a power semiconductor element because a general purpose photocoupler uses a phototransistor to receive the light and the long transition time from ON to OFF of this phototransistor must be shortened. The long transition time from ON to OFF of such a phototransistor occurs because of the long time required to eliminate excessive carriers accumulated in the phototransistor.

Fig. 13 is a circuit diagram of a second prior art form of photocoupler circuit for transmitting a signal.

Referring to Fig. 13, a high speed photocoupler 2A is used for insulating and transmitting a signal and instead of a pair of photocouplers as shown in Fig. 12, only a single such photocoupler is provided.

The first and second prior art circuits described above suffer from the disadvantages that:-

1. the photocoupler circuit is complicated and the number of components needed is high because since a general purpose and low speed photocoupler is used, a pair of photocouplers (for start and stop) must be used to realise high speed signal transmission, and

2. a comparatively large drive current is necessary to make the photocouplers conductive.

Moreover, if a high speed photocoupler is to be used, only one photocoupler is necessary but the resulting arrangement still has the disadvantages that:-

1. a high speed photocoupler is expensive;

2. a high speed photocoupler becomes large in size in comparison with a general purpose photocoupler;

3. a high speed photocoupler requires a comparatively large drive current to become conductive.

It is therefore an object of the present invention to realise high speed signal transmission by reducing the need for general purpose and low speed photocouplers and also by reducing the drive current necessary.

According to the present invention there is provided a photocoupler circuit having a light-emitting element arranged to be driven by means of an input signal and a phototransistor arranged to detect the resulting light signal from the light-emitting element and to produce a current in its main current path as a result of said detection, said photocoupler circuit being characterised in that one side of the main current path of the phototransistor is connected to one side of power supply means via a circuit portion connected in parallel with the current path between the control electrode and one side of the main current path of a switching transistor, the other side of the main current path of the phototransistor being connected to the other side of the power supply means, the voltage across the main current path of the switching transistor being arranged to provide an output signal of the photocoupler circuit.

Embodiments of this invention will now be described, by way of example, with reference to the accompany drawings in which:-

Fig. 1 is a circuit diagram of a photocoupler circuit in a first embodiment of the present invention;

Fig. 2 is a timing diagram for the operation of the circuit shown in Fig. 1;

Figs. 3 to 5 are circuit diagrams of photocoupler circuits in second to fourth embodiments respectively of the present invention;

Figs. 5 to 7 are circuit diagrams of respective different forms of apparatus in which the first embodiment of photocoupler circuit has been applied;

Figs. 8 to 11 are circuit diagrams of photocoupler circuits in respective fifth to eighth embodiments of the present invention for driving a power semiconductor element; and

Figs. 12 and 13 are circuit diagrams of first and second prior art forms of photocoupler circuit for transmitting a signal.

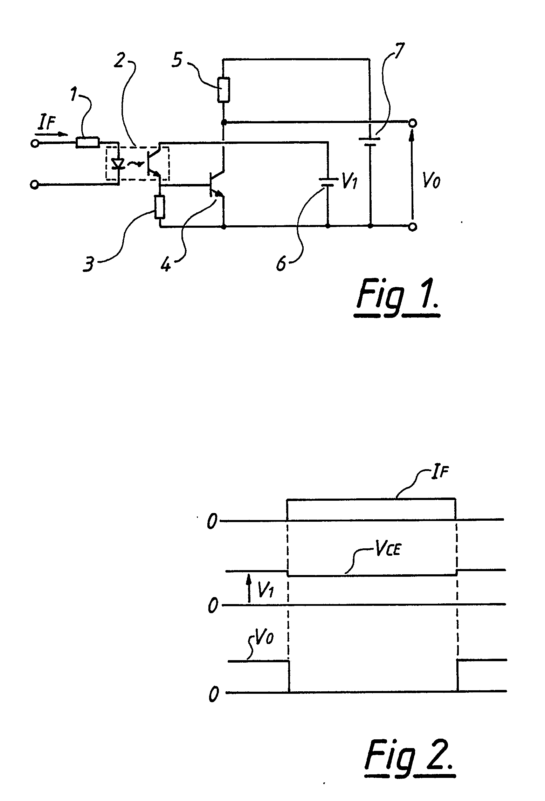

Referring to Fig. 1, an input resistance 1 is provided in the input side (having associated input terminals) of a general purpose or low speed photocoupler 2 (hereinafter only referred to as a photocoupler) and the value of the drive current IF of the photocoupler 2 is determined by means of a voltage applied to the input terminals and the value of the input resistance 1.

When the drive current $I_F$ flows, a phototransistor forming the output side of the photocoupler 2 switches ON. This phototransistor has its emitter connected to resistor 3 connected between the base and emitter of an NPN switching transistor 4 and is further connected with a first DC power supply 6. When the voltage provided by this first DC power supply 6 is $V_1$ and the voltage across the base and emitter of the switching transistor 4 is $V_{BE}{}^*$, then the voltage $V_{CE}$ across collector and emitter of the phototransistor is expressed by the following equation (1). $V_{CE} = V_1 - V_{BE}{}^* ...................(1)$

Here, since $V_{BE}{}^*$ is set to a value as low as about 0.6 to 0.7 volts, $V_{CE}$ becomes almost equal to the voltage $V_1$ of the first DC power supply 6 and the phototransistor is biassed in the active region. Accordingly, the switching speed of photocoupler 2 is improved remarkably.

Referring now also to Fig. 2, graph 2(a) represents changes with time in the current $I_F$ for driving the photocoupler 2; graph 2(b) represents changes with time of output voltage $V_{CE}$ of the photocoupler 2 and graph 2(c), changes with time of an output voltage $V_0$ of the entire photocoupler circuit.

As is obvious from Figs. 1 and 2, when the photocoupler drive current $I_F$ rises then, after a short delay, a current, which is determined by the characteristic of the phototransistor, flows in the phototransistor through the circuit path comprising the first DC power supply 6, the collector of the phototransistor, the base of the switching transistor 4 and the first DC power supply 6. As a result, the switching transistor 4 becomes conductive and the output voltage $V_0$ of the circuit goes low level.

When the photocoupler drive current $I_F$ falls to a low level, the carriers accumulated in the switching transistor 4 are exhausted through resistor 3, this switching transistor 4 switches OFF and the output voltage $V_0$ of the circuit goes high level, that is, becomes equal to the voltage of a second DC power supply 7 connected via resistor 5. Here, the resistor 3 may be omitted if the carrier dissipation time of the switching transistor 4 is to be very short.

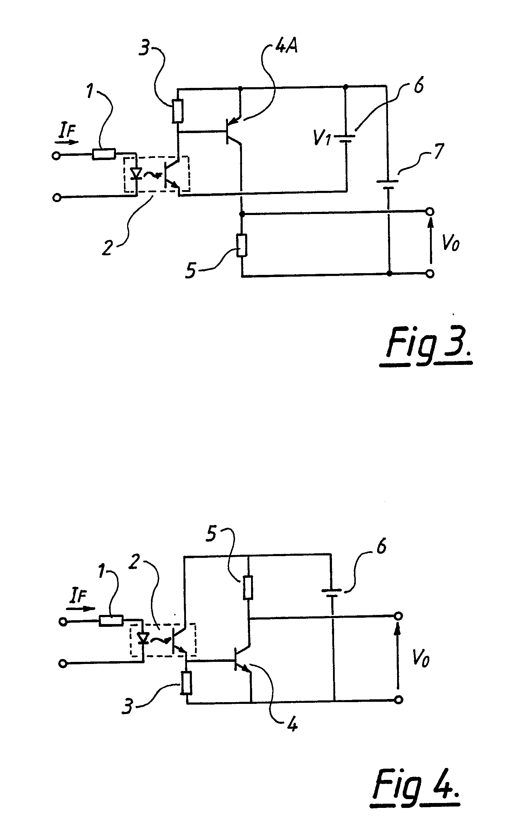

Referring to Fig. 3, switching transistor 4A is a PNP transistor and the functions of the input resistor 1, photocoupler 2 and resistors 3 and 5, first DC power supply 6 and second DC power supply 7 are the same as in the first embodiment but with the difference in connection and polarity corresponding to the use of a PNP transistor 4A.

Referring to Fig. 4, the photocoupler circuit shown is the same as the first embodiment shown in Fig. 1, except that the first DC power supply 6 is used both for power supply to the phototransistor of the photocoupler 2 and to the switching transistor 4. The second DC power supply 7 is thus eliminated.

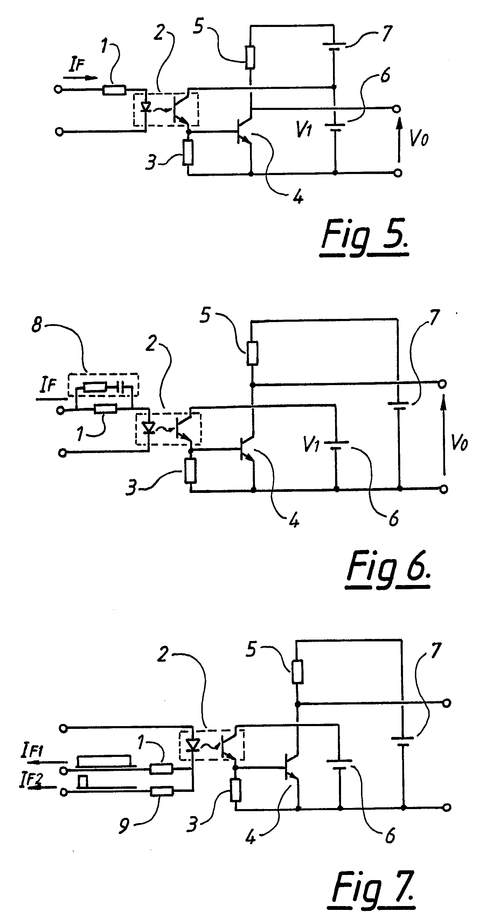

Referring to Fig. 5, the fourth embodiment of photocoupler circuit shown is the same as the first embodiment shown in Fig. 1, except that the first DC power supply 6 is provided for the phototransistor of photocoupler 2, while a series connected arrangement of the first DC power supply 6 and the second DC power supply 7 is provided for the switching transistor 4.

Referring to Fig. 6, in a first form of apparatus using a photocoupler circuit the output circuit following the photocoupler 2 is the same as for the first embodiment shown in Fig. 1 but the signal input circuit to the photocoupler 2 is different.

The input resistor 1 provided in the input side of photocoupler 2 is connected with a differential circuit 8 formed by a resistor and a capacitor to amplify variation in photocoupler drive current $I_F$. Therefore, the signal transmission period for turning ON the photocoupler 2 can be shortened.

Referring to Fig. 7, a second form of apparatus using a photocoupler circuit also shortens the signal transmission period for turning ON the photocoupler. The apparatus is similar to that shown in Fig. 6 but has a different input circuit arrangement in that drive current $I_{F2}$ flowing into input resistor 9 is superposed on the drive current $I_{F1}$ flowing into the input resistor 1 provided in the input side of the photocoupler 2.

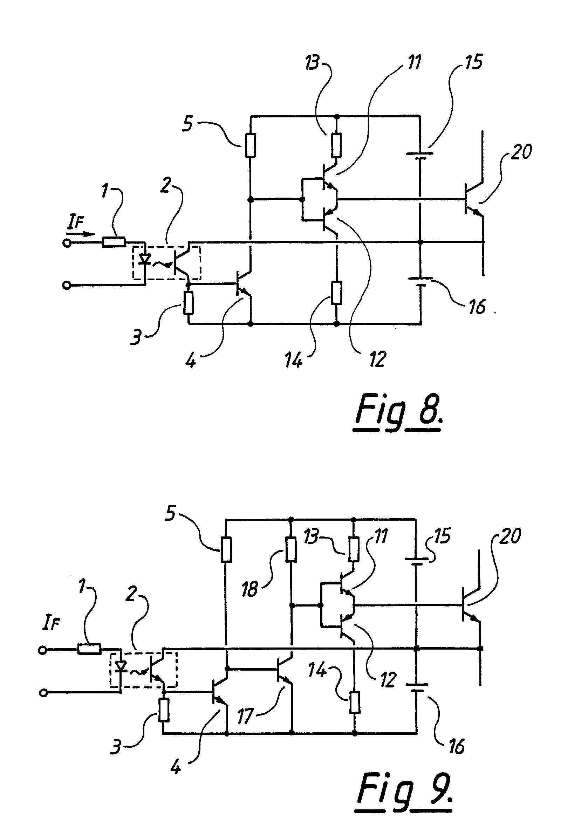

Referring to Fig. 8, an input operating signal is supplied to, and isolated by means of, the photocoupler 2 which transmits the signal at high speed in order to turn ON and OFF a semiconductor power element in the form of power transistor 20. For this purpose, the common connecting point of the gate and emitter of the switching transistor 4 is connected to the phototransistor of a photocoupler 2 and a reverse-bias power supply 16 of the power transistor 20 is connected in the resulting circuit so that the transistor 20 is normally reverse-biassed until the occurrence of an appropriate input signal. Moreover, a series arrangement of the reverse-bias power supply 16 and forward-bias power supply 15 is connected between the collector and emitter of the switching transistor 4 and operation of this switching transistor 4 gives rise to a signal at the gates of forward-bias transistor 11 and reverse-bias transistor 12.

With such a circuit, since excessive carriers are not accumulated in the phototransistor, the time delay in signal transmission when drive current $I_F$ input to the photocoupler 2 goes to zero can be made very short so that the performance of a power conversion unit utilising the power transistor 20 can be improved outstandingly

Moreover, the current transmission ratio of the photocoupler 2 becomes very large because the switching transistor 4 can be driven with only a little current while the photocoupler is operated in the active region. That is, the value of the drive current $I_F$ of the photocoupler 2 can be reduced in comparison with the corresponding value in prior art circuits.

Referring to Fig. 9, a sixth embodiment of photocoupler circuit is for driving a semiconductor power element and is the same as the fifth embodiment shown in Fig. 8, except that an amplifying transistor 17 is provided as a further stage to the switching transistor 4 to operate the forward-bias transistor 11 and the reverse-bias transistor 12.

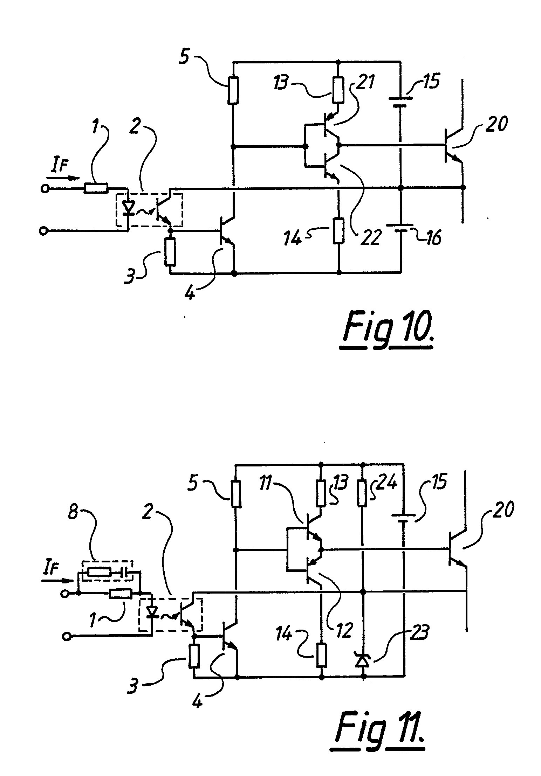

Referring to Fig. 10, a seventh embodiment of photocoupler circuit for driving a semiconductor power element is the same as the fifth embodiment shown in Fig. 8, except that a PNP transistor is used for the forward-bias transistor 21 and an NPN transistor is used for the reverse-bias transistor 22.

Referring to Fig. 11, a series arrangement of resistor 24 and constant voltage (zener) diode 23 is connected to the forward-bias power supply 15 in order to enable the constant voltage diode 23 to provide the function of a reverse-bias power supply so that one DC power supply can be omitted. Moreover, the signal input circuit to the photocoupler 2 is different from that in the fifth embodiment shown in Fig. 8.

A differential circuit 8 comprising a resistor and a capacitor is connected in parallel with the input resistor 1 provided in the input side of the photocoupler 2 to amplify variation in the photocoupler drive current $I_F$ so that the signal transmission time for turning ON the photocoupler 2 can be shortened.

The system of using two parallel-connected resistors 1 and 9 to increase photocoupler drive current as shown in Fig. 7, or the system of using a differential circuit 8 as shown in Figs. 6 and 11 and a system using a constant voltage diode 23 as shown in Fig. 11 as the DC power supply can be applied as appropriate in any of the other embodiments not employing such systems.

Since the photocoupler circuit is so structured that the phototransistor of the photocoupler, the circuit across the base and emitter of the switching transistor and the first DC power supply are connected in series, the photocoupler is used as a current output switch operating in the active region. With an output signal being extracted from the collector of the switching transistor, even using a general purpose photocoupler having transmission delay when going to the OFF signal state, the signal can be transmitted at a high speed and it is no longer necessary to use a large and expensive high speed photocoupler. Thus, a general purpose photocoupler may be used in a power conversion unit which is particularly required to provide high speed operation, resulting in the effect that the entire unit may be reduced in size and can be built at low cost. In addition, the photocoupler may be used as a current output switch with reduced photocoupler drive because it provides a high current transmission ratio. In this aspect the embodiments described above provide a significant contribution to realisation of small size and low cost.

In the embodiments described above the connecting point to the base-emitter junction of the switching transistor is connected in series with the collector and emitter terminals of the phototransistor of the photocoupler and a voltage is applied to this circuit. Thus, even when said phototransistor is in the ON state, excessive carriers are not accumulated by operating such phototransistor in the active region and the transition time from the ON to OFF state can also be shortened. The collector voltage of the phototransistor is almost equal to the power supply voltage applied when the photocoupler is in either the ON or OFF state. Therefore, the phototransistor operates as a current output type switch with reduced drive current.

**Claims**

1. A photocoupler circuit having a light-emitting element arranged to be driven by means of an input signal and a phototransistor arranged to detect the resulting light signal from the light-emitting element and to produce a current in its main current path as a result of said detection, said photocoupler circuit being characterised in that one side of the main current path of the phototransistor is connected to one side of power supply means via a circuit portion connected in parallel with the current path between the control electrode and one side of the main current path of a switching transistor, the other side of the main current path of the phototransistor being connected to the other side of the power supply means, the voltage across the main current path of the switching transistor being arranged to provide an output signal of the photocoupler circuit.

2. A photocoupler circuit according to claim 1, wherein the switching transistor is a junction transistor and the main current path of the phototransistor is connected to the base-emitter junction of the switching transistor and said output signal is obtained between the collector and emitter of the switching transistor.

3. A photocoupler circuit according to claim 1 or claim 2, wherein the light-emitting element of the photocoupler is connected to means for amplifying changes in said input signal.

4. A photocoupler circuit according to any one of the preceding claims, wherein said output signal is used to drive a semiconductor power element.

5. A photocoupler circuit according to claim 4, wherein the output signal is arranged to reverse bias the semiconductor power element until switched by means of an appropriate input signal.

_Fig 1._

_Fig 2._

_Fig 3._

_Fig 4._

_Fig 5._

_Fig 6._

_Fig 7._

Fig 8.

Fig 9.

_Fig 10._

_Fig 11._

_Fig 12._

_Fig 13._

European Patent Office

# EUROPEAN SEARCH REPORT

Application number

## DOCUMENTS CONSIDERED TO BE RELEVANT

EP 90300392.9

| Category | Citation of document with indication, where appropriate, of relevant passages | Relevant to claim | CLASSIFICATION OF THE APPLICATION (Int. Cl.⁵) |
|---|---|---|---|
| X | DE - A - 2 163 495 (GEHAP) * Fig. 2 * | 1,2,4 | H 03 K 17/78 |
| Y |  | 1,3 |  |
| X | DE - B2 - 2 253 423 (INT. RECTIFIER) * Fig. 2, pos. 34,33,30,31,40, 42,25 * | 1,2,4 |  |
| Y |  | 1,3 |  |
| X | DE - A1 - 2 344 891 (HOFFMANN) * Totality * | 1,2,4 |  |
| X | US - A - 4 021 683 (SPLATT) * Fig. 1 * | 1,2 |  |
| A | US - A - 4 137 428 (FEDERICO et al.) * Totality * | 1,2,4, 5 | TECHNICAL FIELDS SEARCHED (Int. Cl.⁵) |
| Y | US - A - 4 355 237 (HARRIS, JR.) * Fig. 1 * | 1,3 | H 03 K 17/00 |
| Y | US - A - 4 369 371 (HARA et al.) * Fig. 1 * | 1,3 |  |
| A | DE - A1 - 2 930 176 (TEXAS INSTRUMENTS) * Fig. 1 * | 1-5 |  |

The present search report has been drawn up for all claims

| Place of search | Date of completion of the search | Examiner |
|---|---|---|
| VIENNA | 22-03-1990 | BAUMANN |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82